# EUROPEAN PATENT APPLICATION

(11) **EP 4 362 094 A1**
(43) Date of publication of application: **01.05.2024**
(21) Application number: 23202711.0
(22) Date of filing: 10.10.2023
(51) Int. Cl.: H01L 27/02, H01L 21/8238, H01L 23/528, H01L 27/06, G06F 30/394, H01L 27/118

(54) **CELL ARCHITECTURE WITH CENTER-LINE POWER RAILS FOR STACKED FIELD-EFFECT TRANSISTORS**

(30) Priority: 26.10.2022 US 202263381064 P; 12.04.2023 US 202318133872
(71) Applicant: Samsung Electronics Co., Ltd., Suwon-si, Gyeonggi-do 16677 (KR)
(72) Inventor: PARK, Panjae, San Jose, CA, 95134 (US); KIM, Jintae, San Jose, CA, 95134 (US); PARK, Hyoeun, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

A cell architecture including at least one semiconductor device cell is provided. The cell includes: a 1^{st} active pattern and a 2^{nd} active pattern extended in a 1^{st} direction, the 1^{st} active pattern at least partially overlapping the 2^{nd} active pattern in a 3^{rd} direction intersecting the 1^{st} direction; a plurality of gate structures extended in a 2^{nd} direction across the 1^{st} and 2^{nd} active patterns, the 2^{nd} direction intersecting the 1^{st} direction and the 3^{rd} direction; a plurality of metal lines in at least one metal layer of the cell, the metal lines being extended in the 1^{st} direction, and at least one of the metal lines being connected to at least one of the 1^{st} and 2^{nd} active patterns and the gate structures; and at least one power rail connecting the at least one of the 1^{st} and 2^{nd} active patterns to at least one voltage source, wherein the at least one power rail is disposed to be closer to a virtual horizontal center line of the cell extended in the 1^{st} direction than an upper boundary or a lower boundary of the cell.

## Description

### BACKGROUND

### 1. Field

Apparatuses consistent with example embodiments of the disclosure relate to a semiconductor device cell architecture in which power rails are formed at a center line area of a cell including stacked field-effect transistors.

### 2. Description of Related Art

Growing demand for a scaled-down cell architecture including a plurality of field-effect transistors requires formation of complex back-end-of-line (BEOL) metal lines and middle-of-line (MOL) contact plugs in a very limited cell area.

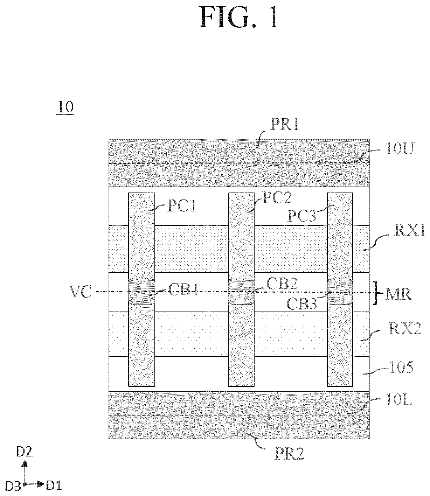

FIG. 1 illustrates a plan view of a simplified semiconductor device cell in which two active patterns for field-effect transistors formed at a vertically-same level are separated from each other, according to a related art.

Referring to FIG. 1, a semiconductor device cell 10 may include two active patterns RX1 and RX2, and a plurality of gate structures PC1-PC3 formed on a substrate 105 between two power rails PR1 and PR2 directly connected to a positive voltage source (Vdd) and a ground voltage source (Vss), respectively. The active patterns RX1, RX2 and the power rails PR1, PR2 are extended in a D1 direction, which is a channel-length direction, and the gate structures PC1-PC3 are extended in a D2 direction, which is a channel-width direction. The channel-length direction may also be referred to as a cell-length direction, and the channel-width direction may also be referred to as a cell-height direction. The power rails PR1 and PR2 are formed at an upper boundary 10U and a lower boundary 10L of the cell 10, respectively. The active patterns RX1 and RX2 are formed between the power rails PR1 and PR2, and separated from each other in the D2 direction in the cell 10. The power rails PR1 and PR2 may be directly connected to Vdd and Vss or connected thereto through a voltage regulator circuit.

Each of the active regions RX1 and RX2 may be provided to form a channel structure and source/drain regions connected by the channel structure for at least one p-type metal-oxide-semiconductor field-effect transistor (PMOS) or at least one n-type metal-oxide-semiconductor field-effect transistor (NMOS).

In order to complete a logic circuit in the cell 10, a plurality of BEOL metal lines and MOL contact plugs connecting the BEOL metal lines to the active patterns RX1 and RX2 may be formed across the cell 10 at a plurality of levels or layers above the active patterns RX1 and RX2 or the substrate 105. For example, in a plan view of the cell 10, a plurality of gate contact plugs CB1-CB3 of the respective gate structures PC1-PC3 may be formed in an MOL region MR provided between the two active patterns RX1 and RX2 to connect one or more of the gate structures PC1-PC3 to the BEOL metal lines. The MOL region MR may be formed at around a virtual horizontal center line VC of the cell 10 such that the MOL region MR does not overlap the active patterns RX1 and RX2. The MOL region MR may be provided for formation of at least the gate contact plugs CB 1-CB3 therein with less complexity in the cell 10.

However, with introduction of a three-dimensionally-stacked field-effect transistor (3DSFET) in which two or more field-effect transistors are vertically stacked in a D3 direction perpendicular to the D1 direction and the D2 direction, the MOL region MR in the cell 10 may become more congested due to the stack structure of the 3DSFET.

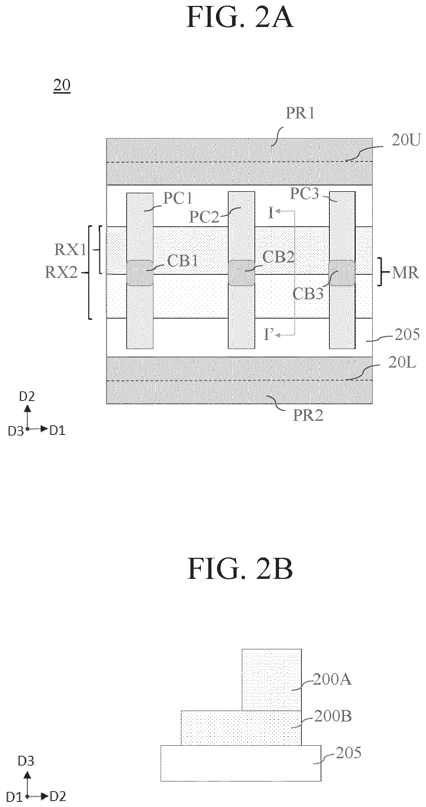

FIG. 2A illustrates a plan view of a simplified semiconductor device cell in which two active patterns are vertically stacked to form a 3DSFET structure, according to a related art, and FIG. 2B illustrated a cross-section view taken along a line I-I' shown in FIG. 2A.

Referring to FIGS. 2A-2B, a semiconductor device cell 20 may include two vertically-stacked active patterns RX1 and RX2, and a plurality of gate structures PC1-PC3 formed on a substrate 205 between two power rails PR1 and PR2 respectively connected to Vdd and Vss. The active patterns RX1, RX2 and the power rails PR1, PR2 are extended in the D1 direction, and the gate structures PC1-PC3 are extended in the D2 direction. The power rails PR1 and PR2 are formed at an upper boundary 20U and a lower boundary 20L of the cell 20, respectively.

In the cell 20, the active pattern RX1 stacked above the active pattern RX2 may have a smaller width than the active pattern RX2 in the D2 direction, and thus, the two active patterns RX1 and RX2 partially overlap each other on the substrate 205 to form a 3DSFET. Thus, a portion of the active pattern RX2 not vertically overlapped by the active pattern RX1 may be exposed in the D3 direction as shown in FIG. 2A. Although not shown, the active patterns RX1 and RX2 may be isolated from each other through an isolation layer therebetween.

However, in the cell 200, an MOL region MR formed at around a virtual horizontal center line of the cell 20 is no longer free of active patterns vertically therebelow. Thus, the formation of MOL contact plugs such as gate contact plugs CB 1-CB3 in the MOL region which is vertically above the active patterns 100 and 200 for the 3DSFET poses a difficult technical challenge and demands careful design consideration.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

Various example embodiments provide a semiconductor device cell formed of 3DSFETs in which power rails are disposed at a position around a virtual horizontal center line in a cell-length direction or at a position vertically above active patterns of the 3DSFETs, and MOL structures such as gate contact plugs are formed outside the active patterns, thereby avoiding congestion of the MOL structures above the active patterns.

According to embodiments, there is provided a cell architecture including at least one semiconductor device cell which may include: a 1^{st} active pattern and a 2^{nd} active pattern extended in a 1^{st} direction, the 1^{st} active pattern at least partially overlapping the 2^{nd} active pattern in a 3^{rd} direction intersecting the 1^{st} direction; a plurality of gate structures extended in a 2^{nd} direction across the 1^{st} and 2^{nd} active patterns, the 2^{nd} direction intersecting the 1^{st} direction and the 3^{rd} direction; a plurality of metal lines in at least one metal layer of the cell, the metal lines being extended in the 1^{st} direction, and at least one of the metal lines being connected to at least one of the 1^{st} and 2^{nd} active patterns and the gate structures; and at least one power rail connecting the at least one of the 1^{st} and 2^{nd} active patterns to at least one voltage source, wherein the at least one power rail is disposed to be closer to a virtual horizontal center line of the cell extended in the 1^{st} direction than an upper boundary or a lower boundary of the cell.

According to embodiments, there is provided a cell architecture including at least one semiconductor device cell which may include: a 1^{st} active pattern and a 2^{nd} active pattern extended in a 1^{st} direction, the 1st active pattern stacked on the 1^{st} active pattern in a 3^{rd} direction intersecting the 1^{st} direction; a plurality of gate structures extended in a 2^{nd} direction across the 1^{st} and 2^{nd} active patterns, the 2^{nd} direction intersecting the 1^{st} direction and the 3^{rd} direction; and a plurality of metal lines in at least one metal layer of the cell, the metal lines being extended in the 1^{st} direction, wherein at least one of the metal lines is a power rail connecting at least one of the 1^{st} and 2^{nd} active patterns to at least one voltage source, and wherein another at least one of the metal lines is connected to at least one of the 1^{st} and 2^{nd} active patterns and the gate structures.

According to embodiments, there is provided a cell architecture including at least one semiconductor device cell which may include: a 1^{st} active pattern and a 2^{nd} active pattern extended in a 1^{st} direction, the 1st active pattern at least partially overlapping the 2^{nd} active pattern in a 3^{rd} direction intersecting the 1^{st} direction; a plurality of gate structures extended in a 2^{nd} direction across the 1^{st} and 2^{nd} active patterns, the 2^{nd} direction intersecting the 1^{st} direction and the 3^{rd} direction; a plurality of metal lines in at least one metal layer of the cell, the metal lines being extended in the 1^{st} direction, and at least one of the metal lines being connected to at least one of the 1^{st} and 2^{nd} active patterns and the gate structures; and at least one power rail connecting the at least one of the 1^{st} and 2^{nd} active pattern to at least one voltage source, wherein the at least one power rail is disposed to be closer to at least one of the 1^{st} and 2^{nd} active pattern than an upper boundary or a lower boundary of the cell.

According to embodiments, there is provided a cell architecture including at least one semiconductor device cell which may include: a 1^{st} active pattern and a 2^{nd} active pattern extended in a 1^{st} direction, the 1st active pattern stacked on the 2^{nd} active pattern in a 3^{rd} direction intersecting the 1^{st} direction; a plurality of gate structures extended in a 2^{nd} direction across the 1^{st} and 2^{nd} active patterns, the 2^{nd} direction intersecting the 1^{st} direction and the 3^{rd} direction; a plurality of metal lines in at least one metal layer of the cell, the metal lines being extended at least in the 1^{st} direction; and at least one gate contact plug connecting at least one of the gate structures to at least one of the metal lines, wherein the at least one gate contact plug is disposed in a region outside the 1^{st} and 2^{nd} active patterns in a plan view of the cell.

### BRIEF DESCRIPTION OF DRAWINGS

Example embodiments of the disclosure will be more clearly understood from the following detailed description taken in conjunction with the accompanying drawings in which:
FIG. 1 illustrates a plan view of a simplified semiconductor device cell in which two active patterns for field-effect transistors formed at a vertically same level are separated from each other, according to a related art;
FIG. 2A illustrates a plan view of a simplified semiconductor device cell in which two active patterns are vertically stacked to form a 3DSFET structure, according to a related art, and FIG. 2B illustrates a cross-section view taken along a line I-I' shown in FIG. 2A;
FIG. 3 illustrates a plan view of a simplified semiconductor device cell in which two active patterns are vertically stacked to form a 3DSFET, according to an embodiment;
FIG. 4A illustrates a schematic of a buffer circuit, and FIG. 4B is a semiconductor device cell in which a buffer circuit is formed, according to an embodiment;
FIG. 5A illustrates a schematic of a cross-coupled circuit, and FIG. 5B is a semiconductor device cell in which a cross-coupled circuit is formed, according to an embodiment;
FIG. 6 illustrates a cell layout or cell architecture including a plurality of semiconductor device cells for a multi-bit flip-flop, according to an embodiment; and
FIG. 7 is a schematic block diagram illustrating an electronic device including a plurality of 3DSFETs formed in a cell or a cell architecture shown in at least one of FIGS. 3, 4B, 5B and 6, according to an example embodiment.

### DETAILED DESCRIPTION OF EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, nanosheet sacrificial layers, sacrificial isolation layers and channel isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{tn,}" "5^{th}" "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain front-end-of-line (FEOL), MOL or BEOL structure such as a substrate, a source/drain region, a channel structure, a contact plug, a metal line, and an isolation layer of a semiconductor device and materials forming the same may be omitted herein when this structure or layer is not related to the novel features of the embodiments.

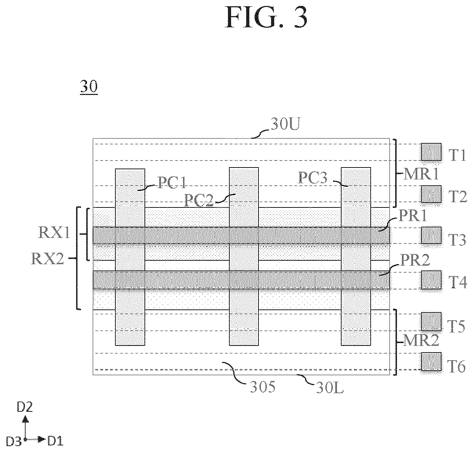

FIG. 3 illustrates a plan view of a simplified semiconductor device cell in which two active patterns are vertically stacked to form a 3DSFET, according to an embodiment.

A semiconductor device cell 30 shown in FIG. 3 has similar components to the semiconductor device cell 20 shown in FIG. 2A, and thus, duplicate descriptions of the gate structures PC1-PC3 and the two vertically-stacked active patterns RX1 and RX2 having different active-pattern widths in the D2 direction on the substrate 305 are omitted herein.

However, the cell 30 may differ from the cell 20 in that two power rails PR1 and PR2 are formed proximal to the horizontal center line of the cell 30 (rather than at the top and bottom), and 1^{st} and 2^{nd} MOL regions MR1 and MR2 are formed at an upper side and a lower side of two active patterns RX1 and RX2 in the cell 30, respectively, instead of at the horizontal center line of the cell 30. An upper boundary 30U and a lower boundary 30L of the cell 30, where the power rails PR1 and PR2 are formed in the cell 20 of FIG. 2A, may now be no longer overlapped by the power rails PR1 and PR2 in the the cell 30, respectively. Thus, the cell 30 may have an increased area in the 1^{st} and 2^{nd} MOL regions MR1 and MR2 where MOL contact plugs and BEOL metal lines can be disposed. Further, the cell 30 may be able to avoid formation of gate contact plugs for the gate structures PC1-PC3 at positions vertically above the active patterns RX1 and RX2 of 3DSFETs.

According to an embodiment, the cell 30 may have six metal-line tracks T1-T6 extended in the D1 direction and arranged in the D2 direction at a predetermined metal pitch. The metal-line tracks T1-T6 may be spaces provided as a BEOL of the cell 30 to accommodate a plurality of metal lines therein. According to an embodiment, the metal-line tracks T1-T6 may be virtual tracks or may take a form of trench in an interlayer dielectric (ILD) structure in the BEOL of the cell 30. Thus, the metal lines formed in or corresponding to the metal-line tracks T1-T6 may be referred to as BEOL structures or interconnects. According to an embodiment, the metal-line tracks T1-T6 and the metal lines formed therein or corresponding thereto may be positioned inside the upper boundary 30U and the lower boundary 30L of the cell 30. Thus, the upper-most metal-line track T1 and the lower-most metal-line track T6 and metal lines formed therein or corresponding thereto may not vertically overlap the upper boundary 30U and the lower boundary 30L of the cell 30 in the D3 direction, unlike the power rails PR1 and PR2 of the cell 10 in FIG. 1 and the cell 20 in FIG. 2A.

According to an embodiment, the power rails PR1 and PR2 may be respectively aligned with the metal-line tracks T3 and T4 which may vertically overlap the active patterns RX1 and RX2 or which may be formed at around or proximal to a horizontal center line of the cell 30. Thus, the power rails PR1 and PR2 may be metal lines formed in or corresponding to the metal-line tracks T3 and T4, respectively. According to an embodiment, the power rails PR1 and PR2 may vertically overlap only one of the two active patterns RX1 and RX2 depending on other cell design factors such as the number of metal lines required for a logic circuit implemented by the cell 30. For example, when the 1^{st} MOL region MR1 requires more metal line tracks or metal lines than the 2^{nd} MOL region MR2, the power rails PR1 and PR2 may be positioned closer to the lower boundary 30L than the upper boundary 30U to provide a greater height in the D2 direction to the 1^{st} MOL region MR1. Thus, the power rails PR1 and PR2 may be metal lines formed in or corresponding to the metal-line tracks T4 and T5 instead of T3 and T4. Still, however, the power rails PR1 and PR2 may not overlap or may not be positioned above the lower boundary 30L of the cell 30.

According to an embodiment, the power rails PR1 and PR2 may have the same width as the other metal lines, for example, BEOL interconnects, formed in the metal-line tracks T1-T6, which is smaller than that of each power rail formed at the boundaries of the related-art cells 10 and 20 shown in FIGS. 1 and 2, respectively. As the cell 30 dispenses with wide power rails on the upper boundary 20U and the lower boundary 20L of the cell 20, an entire area of the cell 30 may become smaller than that of the cell 20 shown in FIG. 2A.

According to an embodiment, an upper field-effect transistor including the 1^{st} active pattern RX1 may have a smaller channel width than a lower field-effect transistor including the 2^{nd} active pattern RX2 due to the difference of the active-pattern widths. Here, the field-effect transistor may refer to a fin field-effect transistor (FinFET) having at least one fin structure as a channel structure thereof or a nanosheet transistor having two or more nanosheet layers as a channel structure thereof, not being limited thereto.

Herebelow, embodiments of a standard cell architecture implementing at least one logic circuit are provided, in which power rails are formed at a position around and proximal to a virtual horizontal center line of a cell or at a position vertically above at least one active pattern in the cell as shown in FIG. 3.

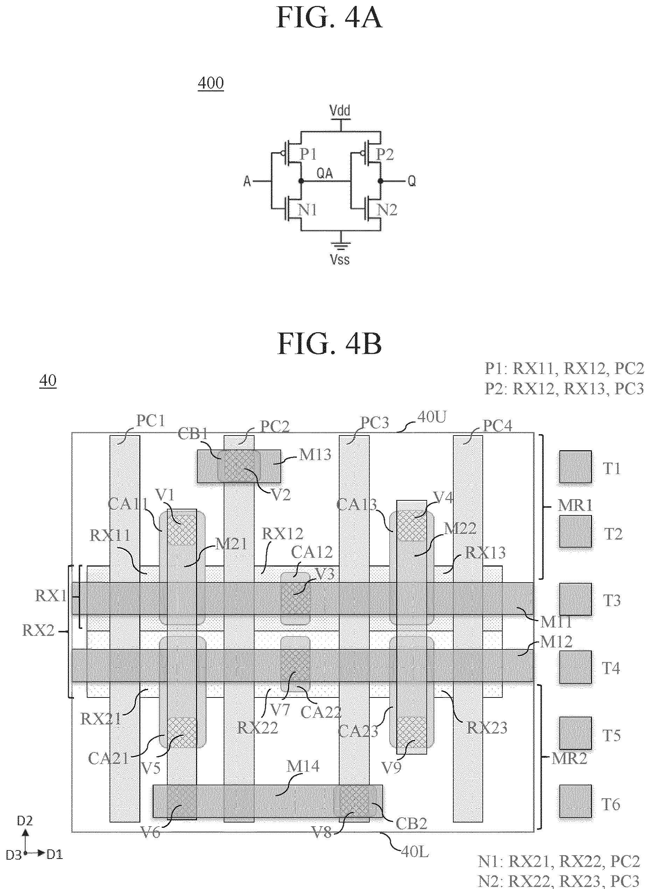

FIG. 4A illustrates a schematic of a buffer circuit, and FIG. 4B is a semiconductor device cell in which a buffer circuit is formed, according to an embodiment.

Referring to FIG. 4A, a buffer circuit 400 may be constituted by two inverter circuits connected to each other in parallel between Vdd and Vss. The two inverter circuits may be formed by an input complimentary metal-oxide-semiconductor (CMOS) inverter and an output CMOS inverter which receives an output signal of the input CMOS inverter as an input signal of the output CMOS inverter. The input CMOS inverter may be formed by a PMOS P1 and an NMOS N1 serially connected to each other between Vdd and Vss. The output CMOS inverter may be formed by a PMOS P2 and an NMOS N2 which are also serially connected to each other between Vdd and Vss.

Referring to FIG. 4B, a semiconductor device cell 40 in which the buffer circuit 400 is implemented may have a cell structure similar to the cell 30 shown in FIG. 3. Thus, the cell 40 may include vertically-stacked 1^{st} and 2^{nd} active patterns RX1 and RX2 extended in the D1 direction, and 1^{st} to 4^{th} gate structures PC1-PC4 extended in the D2 direction across the active patterns RX1 and RX2, and arranged in the D1 direction at a predetermined gate pitch. A horizontal distance between two neighboring gate structures may be referred to as one (1) contact-poly-pitch (1 CPP). Further, in the cell 40, 1^{st} and 2^{nd} MOL regions MR1 and MR2 are formed at an upper side and a lower side of the 1^{st} and 2^{nd} active patterns RX1 and RX2, respectively, inside an upper boundary 40U and a lower boundary 40L.

The 1^{st} active pattern RX1 may include 1^{st} to 3^{rd} source/drain regions RX11-RX13 respectively divided by the 2^{nd} and 3^{rd} gate structures PC2 and PC3. The 1^{st} and 2^{nd} source/drain regions RX11 and RX12, the 2^{nd} gate structure PC2, and a channel structure connecting the 1^{st} source/drain region RX11 to the 2^{nd} source/drain region RX12 below the 2^{nd} gate structure PC2 may form the PMOS P1 of the buffer circuit 400. The 2^{nd} and 3^{rd} source/drain regions RX12 and RX13, the 3^{rd} gate structure PC3, and a channel structure connecting the 2^{nd} source/drain region RX12 to the 3^{rd} source/drain region RX13 below the 3^{rd} gate structure PC3 may form the PMOS P2 of the buffer circuit 400. The 2^{nd} source/drain region RX12 may be a common source/drain region for the PMOS P1 and the PMOS P2 commonly connected to Vdd as described later.

Similarly, the 2^{nd} active pattern RX2 may include 4^{th} to 6^{th} source/drain regions RX21-RX23 respectively divided by the 2^{nd} and 3^{rd} gate structures PC2 and PC3. The 4^{th} and 5^{th} source/drain regions RX21 and RX22, the 2^{nd} gate structure PC2, and a channel structure connecting the 4^{th} source/drain region RX21 to the 5^{th} source/drain region RX22 below the 2^{nd} gate structure PC2 may form the NMOS N1 of the buffer circuit 400. The 5^{th} and 6^{th} source/drain regions RX22 and RX23, the 3^{rd} gate structure PC3, and a channel structure connecting the 5^{th} source/drain region RX22 to the 6^{th} source/drain region RX23 below the 3^{rd} gate structure PC3 may form the NMOS N2 of the buffer circuit 400. The 5^{th} source/drain region RX22 may be a common source/drain region for the NMOS N1 and the NMOS N2 commonly connected to Vss as described later. The channel structures formed below the 2^{nd} and 3^{rd} gate structures PC2 and PC3 are not shown in FIG. 4B, which is a plan view.

The cell 40 may also include a plurality of MOL contact plugs CA11-CA13, CA21-CA23, CB1 and CB2, metal lines M11-M14, M21 and M22 and via structures V1-V9 connecting one or more of the active patterns RX11-RX13 and RX21-RX23 and the gate structures PC2-PC3 to each other, to another circuit element outside the cell 40, and/or to Vdd and Vss to power the buffer circuit 400.

Similar to the cell 30 of FIG. 3, the cell 40 may have metal-line tracks T1-T6 extended in the D1 direction and arranged in the D2 direction at a predetermined metal pitch, among which the metal-line tracks T1 and T6 are disposed at positions close to the upper boundary 40U and the lower boundary 40L of the cell 40, respectively. Also, the metal-line tracks T1-T6 in the cell 40 may be virtual tracks or may take a form of trench in an ILD structure in a BEOL of the cell 40.

In the present embodiment, the metal-line tracks T1-T6 may be formed in or correspond to a 1^{st} metal layer, which is the lowest metal layer in a BEOL structure of the cell 40 in the D3 direction. The metal lines M11-M14 may be respectively formed in or correspond to the metal-line tracks T3, T4, T1 and T6 in the 1^{st} metal layer. Although not shown in FIG. 4B, the cell 40 may also have metal-line tracks formed in or correspond to a 2^{nd} metal layer extended in the D2 direction and disposed vertically above the 1^{st} metal layer in the D3 direction. Thus, the metal lines M21 and M22 may be formed in or correspond to respective metal-line tracks of the 2^{nd} metal layer. Although not shown, at least one additional via structure may be formed to place the metal lines M21 and M22 above the metal lines M11-M14.

According to an embodiment, the metal lines M11 and M12 formed in or corresponding to the metal-line tracks T3 and T4 may be power rails that are respectively connected to Vdd and Vss. The metal lines M11 and M12 may be disposed along and proximal to or at a virtual horizontal center line of the cell 40. According to an embodiment, among the metal-line tracks T1-T6, the metal-line tracks T3 and T4 may be the closest to the horizontal center line of the cell 40, while the metal-line tracks T1 and T2 may be in the 1^{st} MOL region MR1, and the metal-line tracks T5 and T6 may be in the 2^{nd} MOL region MR2. According to an embodiment, the metal lines M11 and M12 may be disposed in the cell 40 to vertically overlap the two active patterns RX1 and RX2 in the D3 direction. However, as described above for the cell 30 in FIG. 3, the power rails PR1 and PR2 may vertically overlap only one of the two active patterns RX1 and RX2 depending on other cell design factors.

The metal line M11 may connect the 2^{nd} source/drain region RX12, which is a common source region of the PMOS P1 and the PMOS P2, to Vdd through the source/drain contact plug CA12 on the 2^{nd} source/drain region RX12 and the via structure V3 thereon. In contrast, the metal line M12 may connect the 5^{th} source/drain region RX22, which is a common source of the NMOS N1 and the NMOS N2, to Vss through the source/drain contact plug CA22 on the 5^{th} source/drain region RX22 and the via structure V7 thereon.

The metal line M13 which receives an input signal A of the input CMOS inverter as shown in FIG. 4A may be connected to the 2^{nd} gate structure PC2, which is shared by the PMOS P1 and the NMOS N1, through the gate contact plug CB1 thereon and the via structure V2 thereon. That is, the input signal A of the input CMOS inverter may be input through the metal line M13, the via structure V2 and the gate contact plug CB1.

The metal line M21 may receive a drain signal of the PMOS P1 from the 1^{st} source/drain region RX11 through the source/drain contact plug CA11 thereon and the via structure V1 thereon, or a drain signal of the NMOS N1 from the 4^{th} source/drain region RX21 through the source/drain contact plug CA21 thereon and the via structure V5 thereon. The drain signal of the PMOS P1 or the NMOS N1, which is an output signal QA of the input CMOS inverter as shown in FIG. 4A, may be transmitted to the 3^{rd} gate structure PC3, which is shared by the PMOS P2 and the NMOS N2, through the metal line M21, the via structure V6 therebelow, the metal line M14 therebelow, the via structure V8 therebelow, and the gate contact plug CB2 therebelow and on the 3^{rd} gate structure PC3 so that the output signal QA of the input CMOS inverter may become an input signal of the output CMOS inverter as shown in FIG. 4A.

The metal line M22 may receive a drain signal of the PMOS P2 from the 3^{rd} source/drain region RX13 through the source/drain contact plug CA13 thereon and the via structure V4 thereon, or a drain signal of the NMOS N2 from the 6^{th} source/drain region RX23 through the source/drain contact plug CA23 thereon and the via structure V9 thereon. The drain signal of the PMOS P2 or the NMOS N2 may be an output signal Q of the buffer circuit 400 as shown in FIG. 4A.

Thus, the cell 40 for a buffer circuit formed of 3DSFETs may provide an increased area for formation of MOL contact plugs and BEOL metal lines in the MOL regions MR1 and MR2 outside the active patterns RX1 and RX2 by disposing power rails at positions around or proximal to the virtual horizontal center line of the cell 40 or vertically above the active patterns RX1 and RX2 or using metal lines formed at the positions as power rails of the cell 40. Further, the cell 40 may enable formation of the gate contact plugs CB1 and CB2 outside the active patterns RX1 and RX2, that is, in the MOL regions MR1 and MR2, thereby reducing routing complexity above the of the 3DSFET forming the buffer circuit 400. In addition, the cell 40 with the power rails at the above-described positions may enable formation of the 3DSFET buffer circuit 400 in a 2-CPP cell.

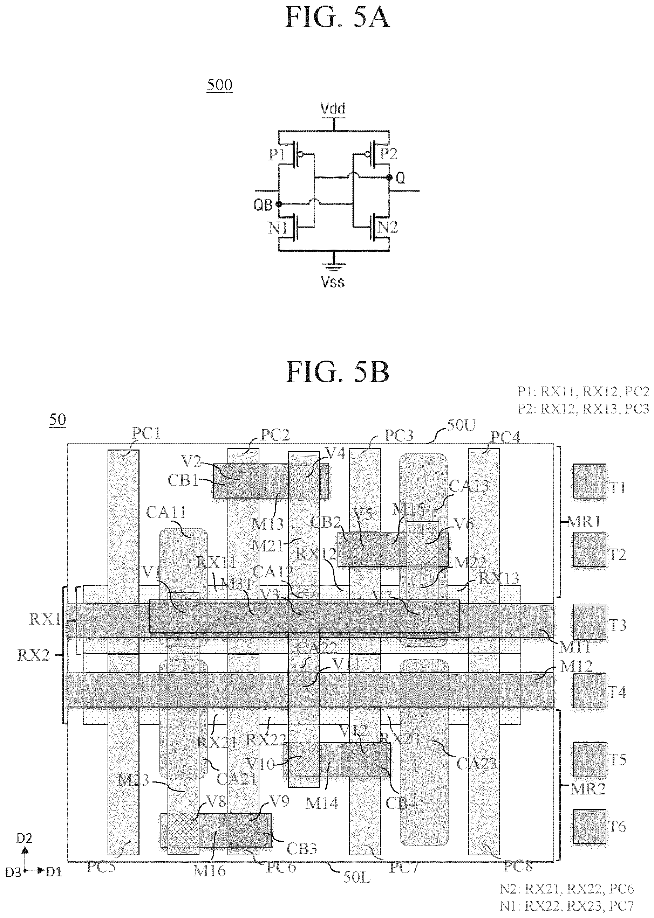

FIG. 5A illustrates a schematic of a cross-coupled circuit, and FIG. 5B is a semiconductor device cell in which a cross-coupled circuit is formed, according to an embodiment.

Referring to FIG. 5A, a cross-couple circuit 500 may be constituted by cross-coupling two inverter circuits, that is, a 1^{st} CMOS inverter and a 2^{nd} CMOS inverter, between Vdd and Vss such that an output signal of the 1^{st} CMOS inverter is input as an input signal of the 2^{nd} CMOS inverter, and an output signal of the 2^{nd} CMOS inverter is input as an input signal of the 1^{st} CMOS inverter. The input CMOS inverter may be formed by a PMOS P1 and an NMOS N1 serially connected to each other between Vdd and Vss. The output CMOS inverter may be formed by a PMOS P2 and an NMOS N2 which are also serially connected to each other between Vdd and Vss. The cross-couple circuit is known to be a fundamental circuit structure used in designing an integrated circuit including a static random access memory (SRAM) and a flip-flop circuit.

Referring to FIG. 5B, a semiconductor device cell 50 in which the cross-couple circuit 500 is implemented may include a 1^{st} active pattern RX1 and a 2^{nd} active pattern RX2 extended in the D1 direction, and having widths in the D2 direction, and stacked in the D3 direction. The cell 60 may also include 1^{st} to 4^{th} gate structures PC1-PC4 extended in the D2 direction across the 1^{st} active pattern RX1 and arranged in the D1 direction at a predetermined gate pitch, and 5^{th} to 8^{th} gate structures PCS-PC8 extended in the D2 direction across the 2^{nd} active pattern RX2 and arranged in the D1 direction at the same predetermined gate pitch as that of the 1^{st} to 4^{th} gate structures PC1-PC4. The 1^{st} to 4^{th} gate structures PC1-PC4 may be aligned with the 5^{th} to 8^{th} gate structures PCS-PC8, respectively, in the D2 direction. The 1^{st} to 4^{th} gate structures PC1-PC4 may be separated from the 5^{th} to 8^{th} gate structures PCS-PC8, respectively, by an isolation layer or a gate cut structure. Further, in the cell 50, 1^{st} and 2^{nd} MOL regions MR1 and MR2 are formed at an upper side and a lower side of the 1^{st} and 2^{nd} active patterns RX1 and RX2, respectively, inside an upper boundary 50U and a lower boundary 50L

The 1^{st} active pattern RX1 may include 1^{st} to 3^{rd} source/drain regions RX11-RX13 respectively divided by the 2^{nd} and 3^{rd} gate structures PC2 and PC3. The 1^{st} and 2^{nd} source/drain regions RX11 and RX12, the 2^{nd} gate structure PC2, and a channel structure connecting the 1^{st} source/drain region RX11 to the 2^{nd} source/drain region RX12 below the 2^{nd} gate structure PC2 may form the PMOS P1 of the cross-couple circuit 500. The 2^{nd} and 3^{rd} source/drain regions RX12 and RX13, the 3^{rd} gate structure PC3, and a channel structure connecting the 2^{nd} source/drain region RX12 to the 3^{rd} source/drain region RX13 below the 3^{rd} gate structure PC3 may form the PMOS P2 of the cross-couple circuit 500. The 2^{nd} source/drain region RX12 may be a common source/drain region for the PMOS P1 and the PMOS P2 commonly connected to Vdd as described later.

Similarly, the 2^{nd} active pattern RX2 may include 4^{th} to 6^{th} source/drain regions RX21-RX23 respectively divided by the 6^{th} and 7^{th} gate structures PC6 and PC7. The 4^{th} and 5^{th} source/drain regions RX21 and RX22, the 6^{th} gate structure PC6, and a channel structure connecting the 4^{th} source/drain region RX21 to the 5^{th} source/drain region RX22 below the 6^{th} gate structure PC6 may form the NMOS N2 of the cross-couple circuit 500. The 5^{th} and 6^{th} source/drain regions RX22 and RX23, the 7^{th} gate structure PC7, and a channel structure connecting the 5^{th} source/drain region RX22 to the 6^{th} source/drain region RX23 below the 7^{th} gate structure PC7 may form the NMOS N1 of the cross-couple circuit 500. The 5^{th} source/drain region RX22 may be a common source/drain region for the NMOS N1 and the NMOS N2 commonly connected to Vss as described later. The channel structures formed below the 2^{nd}, 3^{rd}, 6^{th} and 7^{th} gate structures PC2, PC3, PC6 and PC7 are not shown in FIG. 5B, which is a plan view.

The positions of the NMOS N1 and the NMOS N2 in the cell 50 for the cross-couple circuit 500 are reversed from the positions of the NMOS N1 and the NMOS N2 in the cell 40 for the buffer circuit 400. In other words, in the cell 50 as shown in FIG. 5B, the NMOS N1 forming the 1^{st} CMOS inverter with the PMOS P1 is aligned with the PMOS P2, and the NMOS N2 forming the 2^{nd} CMOS inverter with the PMOS P2 is aligned with the PMOS P1.

The cell 50 may also include a plurality of MOL contact plugs CA11-CA13, CA21-CA23, CB1-CB4, metal lines M11-M16, M21-M23 and M31, and via structures V1-V12 connecting one or more of the active patterns RX11-RX13 and RX21-RX23 and the gate structures PC2-PC3 to each other, to another circuit element outside the cell 50, and to Vdd and Vss to power the cross-couple circuit 500.

Similar to the cell 30 in FIG. 3, the cell 50 may have metal-line tracks T1-T6 extended in the D1 direction and arranged in the D2 direction at a predetermined metal pitch, among which the metal-line tracks T1 and T6 are disposed at positions close to an upper boundary 50U and a lower boundary 50L of the cell 50, respectively. Also, the metal-line tracks T1-T6 in the cell 50 may be virtual tracks or may take a form of trench in an ILD structure in a BEOL of the cell 50.

In the present embodiment, the metal-line tracks T1-T6 may be formed in or correspond to a 1^{st} metal layer, which is the lowest metal layer in a BEOL structure of the cell 50 in the D3 direction. The metal lines M11-M16 may be respectively formed in or correspond to the metal-line tracks T3, T4, T1, T5, T2 and T6 in the 1^{st} metal layer. Although not shown in FIG. 5B, the cell 50 may also have metal-line tracks formed in or correspond to a 2^{nd} metal layer extended in the D2 direction and disposed vertically above the 1^{st} metal layer in the D3 direction, and metal-line tracks formed in or correspond to a 3^{rd} metal layer extended in the D1 direction and disposed vertically above the 2^{nd} metal layer in the D3 direction. Thus, the metal lines M21-M23 may be formed in or correspond to respective metal-line tracks of the 2^{nd} metal layer, and the metal line M31 may be formed in or correspond to respective metal-line tracks of the 3^{rd} metal layer. Although not shown, at least one another via structure may be formed to place the metal lines M21-M23 above the metal lines M1-M6, and place the metal line M31 above the metal lines M21-M23.

According to an embodiment, the metal lines M11 and M12 formed in or corresponding to the metal-line tracks T3 and T4 may be power rails that are respectively connected to Vdd and Vss. The metal lines M11 and M12 may be disposed along, and proximal to or at a virtual horizontal center line of the cell 50. According to an embodiment, among the metal-line tracks T1-T6, the metal-line tracks T3 and T4 may be the closest to the horizontal center line of the cell 50, while the metal-line tracks T1 and T2 may be in the 1^{st} MOL region MR1, and the metal-line tracks T5 and T6 may be in the 2^{nd} MOL region MR2. According to an embodiment, the metal lines M11 and M12 may be disposed in the cell 50 to vertically overlap the two active patterns RX1 and RX2 in the D3 direction. However, as described above for the cell 30 in FIG. 3, the power rails PR1 and PR2 may vertically overlap only one of the two active patterns RX1 and RX2 depending on other cell design factors.

The metal line M11 may connect the 2^{nd} source/drain region RX22, which is a common source region of the PMOS P1 and the PMOS P2, to Vdd through a source/drain contact plug CA12 on the 2^{nd} source/drain region RX12 and the via structure V3 thereon. In contrast, the metal line M12 may connect the 5^{th} source/drain region RX22, which is a common source of the NMOS N1 and the NMOS N2, to Vss through a source/drain contact plug CA22 on the 5^{th} source/drain region RX22 and the via structure V11 thereon.

The 2^{nd} gate structure PC2 of the PMOS P1 may be connected to the 7^{th} gate structure PC7 of the NMOS N1, and the 3^{rd} gate structure PC3 of the PMOS P2 may be connected to the 6^{th} gate structure PC6 of the NMOS N2, in a cross-coupling manner.

For example, the 2^{nd} gate structure PC2 may be connected to the 7^{th} gate structure PC7 through the gate contact plug CB1 on the 2^{nd} gate structure PC2, the via structure V2 thereon, the metal line M13 thereon, the via structure V4 thereon, the metal line M21 thereon, the via structure V10 therebelow, the metal line M14 therebelow, the via structure V12 therebelow and the gate contact plug CB4 therebelow and on the 7^{th} gate structure PC7. As another example, the 3^{rd} gate structure PC3 may be connected to the 6^{th} gate structure PC6 through the gate contact plug CB2 on the 3^{rd} gate structure PC3, the via structure V5 thereon, the metal line 15 thereon, the via structure V6 thereon, the metal line M22 thereon, the via structure V7 thereon, the metal line M31 thereon, the via structure V1 therebelow, the metal line M23 therebelow, the via structure V8 therebelow, and the metal line M16 therebelow, the via structure V9 therebelow and the gate contact plug CB3 therebelow and on the 6^{th} gate structure PC6.

The 2^{nd} and 7^{th} gate structures PC2 and PC7 forming the 1^{st} CMOS inverter may receive a common drain signal of the PMOS P2 and the NMOS N2, that is the output signal Q of the 2^{nd} CMOS inverter, as shown in FIG. 5A, through the source/drain contact plug CA13 on the 3^{rd} source/drain region RX13 (or the source/drain contact plug CA21 on the 4^{th} source/drain region RX21) and a plurality of other metal lines and via structure that are omitted in FIG. 5B for brevity purposes.

The 3^{rd} and 6^{th} gate structures PC3 and PC6 forming the 2^{nd} CMOS inverter may receive a common drain signal of the PMOS P1 and the NMOS N1, that is the output signal QB of the 1^{st} CMOS inverter, through the source/drain contact plug CA11 on the 1^{st} source/drain region RX11 (or the source/drain contact plug CA23 on the 6^{th} source/drain region RX23) and a plurality of other metal lines and via structure that are omitted in FIG. 5B for brevity purposes.

Thus, the cell 50 for a cross-couple circuit formed of 3DSFETs may provide an increased area for formation of MOL contact plugs and BEOL metal lines in the MOL regions MR1 and MR2 outside the active patterns RX1 and RX2 by disposing power rails at positions around the virtual horizontal center line of the cell 40 or vertically above the active patterns RX1 and RX2 or using metal lines formed at the positions as power rails of the cell 40. Further, the cell 50 may enable formation of the gate contact plugs CB1 and CB2 outside the active patterns RX1 and RX2, that is, in the MOL regions MR1 and MR2, thereby reducing routing complexity above the of the 3DSFET forming the cross-couple circuit 500. In addition, the cell 50 with the power rails at the above-described positions may enable formation of the 3DSFET cross-couple circuit 500 in a 2-CPP cell..

As described above, a cell structure in which power rails are formed at around a horizontal center line or vertically above active patterns may be applied to various different semiconductor device cells implementing respective logic circuits such as an inverter, a tristate inverter, a buffer circuit (e.g., FIG. 4A), a cross-couple circuit (FIG. 5A), a latch, etc.

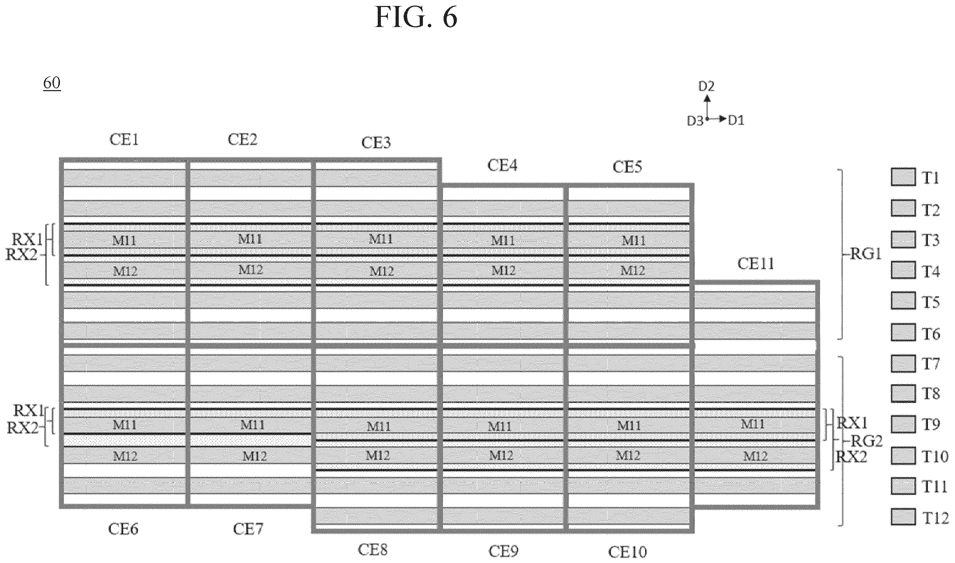

FIG. 6 illustrates a cell layout or cell architecture including a plurality of semiconductor device cells for a multi-bit flip-flop, according to an embodiment.

Referring to FIG. 6, a cell layout 60 may include cells CE1-CE5 at a 1^{st} row region RG1, cells CE6-CE10 at a 2^{nd} row region RG2, and a cell CE11 disposed across the 1^{st} and 2^{nd} row regions RG1-RG2 to implement a multi-bit flip-flop circuit. In the cell layout 60, the cells CE1-CES and CE11 may be serially connected in the D1 direction, and the cells CE6-CE10 and CE11 may be serially connected in the D1 direction. Further, in the cell layout 60, the cells CE1-CE5 may be respectively connected to the cells CE6-CE10 in the D2 direction.

To implement the multi-bit flip-flop circuit, each of the cells CE1-CE11 may include the following logic circuits for the multi-bit flip-flop circuit, for example. The cells CE1 and CE6 may each include an scan-enable inverter. The cells CE2, CE3 and CE7 may each include an input-multiplexer inverter. The cell CE8 may include a clock inverter. The cells CE4 and CE5 may include a 1^{st} master latch and a 1^{st} slave latch, respectively. The cells CE9 and CE10 may include a 2^{nd} master latch and a 2^{nd} slave latch, respectively. The cell CE11 may include an output-signal inverter.

Each of the cells CE1-CE11 for the multi-bit flip-flop circuit may include a 1^{st} active pattern RX1 and a 2^{nd} active pattern RX2, the 1^{st} active pattern RX1 being formed vertically above the 2^{nd} active pattern RX2 in the D3 direction for a 3DSFET structure. Each cell may also include one or more gate structures which are not shown in FIG. 6 for brevity purposes. Further, each cell may include a plurality of metal lines formed along some of metal-line tracks including metal-line tracks T1-T12 at one or more metal layers in a BEOL of the cell.

According to an embodiment, in each of the cells CE1-CE11, power rails connected to Vdd and Vss may be formed at a region around or proximal to a virtual horizontal center line or vertically above the active patterns RX1 and RX2 of the cell. Thus, according to an embodiment, metal lines M11 and M12 formed at the region around or proximal to the horizontal center line or vertically above at least one of the active patterns RX1 and RX2 may be used as the power rails. For example, the metal lines M11 and M12 formed along metal-line tracks T3-T4 for the cells CE1-CE5 and the metal lines M11 and M12 formed along the metal-line tracks T9-T10 for the cells CE6-CE11 may be the power rails.

Further, one or more of the cells CE1-CD 11 may have different channel widths and/or active-pattern widths in the D2 direction, according to an embodiment.

For example, the cells CE1-CE3 and CE8-CD10 may each include six metal lines along the metal-line tracks T1-T6 or T7-T12 formed at an M1 metal layer which is the lowest metal layer in a BEOL of the cell 60. The cells CE4-CE7 may each include five metal lines along the metal-line tracks T2-T6 or T7-T11 formed at the M1 metal layer. The cell CE11 may include seven metal lines along the metal-line tracks T5-T11. One or more metal layers may be formed above the M1 metal layer although not shown in FIG. 6 for brevity purposes.

As another example, the cells CE6-CE7 may have a smaller channel width and/or a smaller active-pattern width than those in the other cells. In the cells CE6-CE7, only the metal line M11 among the metal lines M11 and M12 may be formed vertically above the active patterns RX1 and RX2 due to the smaller active-pattern width, according to an embodiment.

Also, in the cell CE11, the metal lines M11 and M12 may not be formed at around or proximal to a horizontal center line of the cell CE11, although the metal lines M11 and M12 may be formed vertically above the active patterns RX11 and RX12, according to an embodiment.

According to an embodiment, the number of metal-line tracks, the number of metal lines, the channel width, and/or the active-pattern width in each cell may be determined based on design requirements for 3DSFETs included in each cell such as device performance (e.g., a large amount of current flow), power efficiency, the number of required 3DSFETs, etc. For example, the higher the required device performance is, the greater channel width and/or the greater active-pattern width may be implemented in a cell. As another example, the more number of required 3DSFETs is required, the more number of metal line tracks and/or the more number of metal lines may be required in a cell.

Thus, unlike the related-art cell architecture in which a plurality of cells in a same row have a same cell height because of the power rails fixedly formed at upper and lower boundaries of a plurality of cells, the cell architecture or the cell layout 60 may allow the cells CE1-CE11 to have different cell heights depending on the design requirements due to the power rails formed at around or proximal to a horizontal center line of each cell or vertically above at least one of the active patterns of the cell.

In the above, various embodiments of a cell architecture or cell layout for a 3DSFET are described as including two vertically-stacked active patterns having different active-pattern widths and/or different channel widths at a lower stack and an upper stack. However, the disclosure is not limited thereto. The above embodiments may also apply to a 3DSFET including more than two vertically-stacked active patterns, a 3DSFET having a lower-stack active pattern having a smaller active-pattern width and/or channel width than an upper-stack active pattern, a 3DSFET having vertically-stacked active patterns having the same active-pattern width and/or channel width. Further, the embodiments may apply to a cell architecture including a 3DSFET in which at least one of vertically-stacked FETs is a FinFET or a nanosheet transistor. In addition, the above embodiments may apply to a cell architecture including a 3DSFET in which an upper-stack FET is an NMOS and a lower-stack FET is a PMOS, or both FETs are the NMOS or the PMOS. Moreover, the above embodiments may apply to a cell architecture in which more or less than six metal-line tracks are formed in a cell, and more or less than three or four gate structures are formed in a cell. The above embodiments may also apply to a 3DSFET including backside metal lines connecting the active patterns and/or the gate structures to another circuit element or a voltage source.

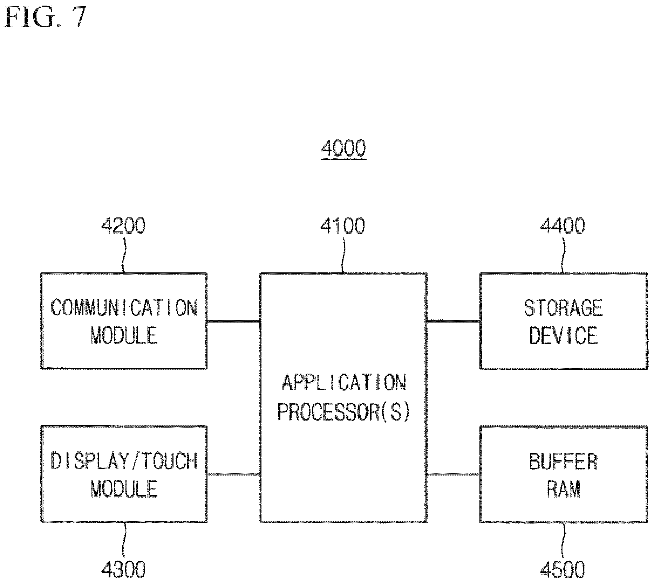

FIG. 7 is a schematic block diagram illustrating an electronic device including a plurality of 3DSFETs formed in a cell or a cell architecture shown in at least one of FIGS. 3, 4B, 5B and 6, according to an example embodiment.

Referring to FIG. 7, an electronic device 4000 may include at least one application processor 4100, a communication module 4200, a display/touch module 4300, a storage device 4400, and a buffer random access memory (RAM) 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 7, the electronic device 4000 may further include at least one sensor such as an image sensor.

At least one component in the electronic device 4000 may be formed based on a cell or a cell architecture of the above embodiments shown in at least one of FIGS. 3, 4B, 5B and 6.

The foregoing is illustrative of example embodiments and is not to be construed as limiting the disclosure. Although some example embodiments have been described above, those skilled in the art will readily appreciate that many modifications are possible in the above embodiments without materially departing from the scope of the appended claims.

## Claims

1. A cell architecture comprising at least one semiconductor device cell which comprises:
a 1^{st} active pattern and a 2^{nd} active pattern extended in a 1^{st} direction, the 1^{st} active pattern at least partially overlapping the 2^{nd} active pattern in a 3^{rd} direction intersecting the 1^{st} direction;
a plurality of gate structures extended in a 2^{nd} direction across the 1^{st} and 2^{nd} active patterns, the 2^{nd} direction intersecting the 1^{st} direction and the 3^{rd} direction;
a plurality of metal lines in at least one metal layer of the cell, the metal lines being extended in the 1^{st} direction, and at least one of the metal lines being connected to at least one of the 1^{st} and 2^{nd} active patterns and the gate structures; and
at least one power rail connecting the at least one of the 1^{st} and 2^{nd} active patterns to at least one voltage source,
wherein the at least one power rail is disposed to be closer to a virtual horizontal center line of the cell extended in the 1^{st} direction than an upper boundary or a lower boundary of the cell.

2. The cell architecture of claim 1, wherein the at least one power rail does not vertically overlap the upper boundary or the lower boundary of the cell in the 3^{rd} direction.

3. The cell architecture of claim 2, wherein the at least one power rail is at least one metal line among the metal lines and is included in a back-end-of-line, BEOL, of the cell.

4. The cell architecture of claim 3, further comprising at least one gate contact plug formed on at least one of the gate structures,
wherein the at least one gate contact plug does not overlap at least one of the 1^{st} and 2^{nd} active patterns.

5. The cell architecture of claim 4, wherein the at least one gate contact plug does not overlap either of the 1^{st} and 2^{nd} active patterns.

6. The cell architecture of any one of claims 3 to 5, wherein the at least one metal line is disposed vertically above at least one of the 1^{st} and 2^{nd} active patterns in the 3^{rd} direction.

7. The cell architecture of claim 6, further comprising at least one gate contact plug formed on at least one of the gate structures,
wherein the at least one gate contact plug does not overlap at least one of the 1^{st} and 2^{nd} active patterns.

8. The cell architecture of any one of claims 1 to 7, wherein the 1^{st} and 2^{nd} active patterns and the gate structures form a logic circuit configured to perform a logic operation.

9. The cell architecture of claim 8, wherein the at least one power rail does not vertically overlap the upper boundary or the lower boundary of the cell in the 3^{rd} direction, and
wherein the cell architecture further includes at least one gate contact plug, and the at least one gate contact plug is formed on at least one of the gate structures such that the at least one gate contact plug does not overlap at least one of the 1^{st} and 2^{nd} active patterns.

10. The cell architecture of any one of claims 1 to 9, wherein the at least one power rail comprises two power rails respectively connected to a positive voltage source and a ground voltage source.

11. The cell architecture of claim 10, wherein the two power rails do not vertically overlap the upper boundary or the lower boundary of the cell in the 3^{rd} direction.

12. The cell architecture of claim 11, wherein the two power rails are disposed vertically above at least one of the 1^{st} and 2^{nd} active patterns in the 3^{rd} direction.

13. The cell architecture of any one of claims 1 to 12, wherein the at least one semiconductor device cell comprises a plurality of cells serially connected and arranged in the 1^{st} direction, and
wherein a cell height of at least one of the cells is different from a cell height of another at least one of the cells.

14. The cell architecture of claim 13, wherein a width of at least one of the 1^{st} and 2^{nd} active patterns in at least one of the cells is different from a width of corresponding at least one of the 1^{st} and 2^{nd} active patterns of another at least one of the cells.

15. The cell architecture of any one of claims 1 to 14, wherein the at least one power rail is another at least one metal line, among the metal lines, included in the lowest metal layer among a plurality of metal layers formed above the cell.
